# EUROPEAN PATENT APPLICATION

(11) **EP 0 997 067 A2**
(43) Date of publication of application: **03.05.2000**
(21) Application number: 99203260.7
(22) Date of filing: 06.10.1999
(51) Int. Cl.: A01K 39/012, H03K 17/945

(54) **Proximity switch**

(30) Priority: 29.10.1998 US 182325
(71) Applicant: CTB, INC., Milford, Indiana 46542-2000 (US)
(72) Inventor: Cole, Theodore John, Milford, Indiana 46642 (US)
(74) Representative: Long, Edward Anthony

(57) **Abstract**

An improved proximity switch (30) has been described. The proximity switch (30) includes control electronics (34) and a sensor (32) . The sensor (32) is remotely mounted from the control electronics (34) and is coupled to it via a wire (33) connection. The switch (30) is more economical to manufacture due to its novel arrangement. The control electronics (34) and the sensor (32) may each be provided with a heating element (36). The heating elements keep the electronics (34) and the sensor (32) warm and prevent moisture from condensing on the electronics (34) and the sensor (32).

## Description

### FIELD OF THE INVENTION

This invention relates to sensing apparatus and in particular to an improved proximity switch for sensing the presence or absence of material.

### BACKGROUND TO THE INVENTION

In the poultry and livestock industry, feed grain is automatically delivered through a system of feed supply pipes, hoppers, feed supply lines and feeder pans. The feed supply pipes are connected to a feed bin in which a large reserve of feed grain is stored. The feed supply pipes deliver feed grain from the feed bin to smaller hoppers which are distributed throughout the areas of a poultry and livestock production house. The smaller hoppers, in turn, supply the feeder pans from which the poultry or livestock eat. Specifically, the feeder pans are supplied with feed grain through a system of feed lines connected to the hopper. The delivery of feed grain from the feed lines to the feeder pans is regulated by an electronic control system.

A key component of the electronic control system is a proximity switch. A predetermined number of proximity switches are operatively coupled to selected feeder pans for controlling the supply of feed grain in the house. A proximity switch typically comprises a proximity sensor which is connected to control circuitry or electronics. The control circuitry or electronics is typically provided in the form of a printed circuit board. The proximity sensor senses the presence or absence of feed grain in the pan and generates an electric signal in accordance with whether or not feed grain has been sensed. The electric signal is transmitted to the control circuitry or electronics which turns the feed line on or off in accordance with the received signal.

Proximity switches of this type are known to suffer from a number of disadvantages. For example, the environmental conditions in which such proximity switches are used often lead to malfunction or even failure of the switches. In particular, the high humidity of poultry or livestock production houses causes moisture to form on the circuitry or electronics, which can damage the circuitry or electronics and lead to failure. Moisture also interferes with the functioning of the proximity sensor and can cause it to generate incorrect signals. The problem of moisture condensation is exacerbated when temperatures fall, e.g., at night time.

Another problem with known proximity switches is that the electronic noise generated by the control circuitry can interfere with the functioning of the proximity sensor. Specifically, the electronic noise can cause the sensor to give inaccurate readings, which leads to errors in the supply of feed. The consequences of such error range include feed overflow from the pan and wastage or insufficient feed, which is detrimental to the growth of the poultry or livestock. Inaccurate readings can also introduce unnecessary wear and tear on the motors which are used to drive the feed through the feed line.

The typical size and shape of proximity switches also gives rise to a disadvantage. In particular, most switches only come in a standard shape and are not readily adaptable to different feeding schemes. Moreover, environmental and performance requirements of known proximity switches limit the type and specifications of the electrical components which are included therein, elevating the expense involved.

### OBJECTS AND SUMMARY OF THE INVENTION

Accordingly, it is general object of the present invention to provide an improved proximity switch.

It is an additional object of the present invention to provide a proximity switch of increased reliability in humid conditions.

It is a related object of the present invention to provide a proximity switch with increased reliability in cold conditions.

Yet another object of the present invention is to provide a proximity switch suitable for use in a variety of applications.

Still another object of the present invention is to provide a proximity switch constituted and arranged in a manner which enables more economical manufacture.

Other objects and advantages will become apparent from the ensuing description.

Accordingly, the present invention provides a proximity switch in which the sensor is remotely mounted from the control circuit for improved function and versatility. Preferably, the present invention also provides a proximity switch including a heating element for maintaining the switch at a predetermined temperature and causing the dissipation of moisture.

### BRIEF DESCRIPTION OF THE DRAWINGS

The present invention will now be described by way of example with reference to the accompanying drawings in which:
FIG. 1 is a front perspective view of a feeder pan including a proximity switch according to the invention;
FIG. 2 is a front perspective view of a proximity switch according to the invention;
FIG. 3 is a detailed sectional view of a top portion of the feeder pan in which a proximity sensor according to the invention is located;
FIG. 4 is a top plan view of a feeder pan including a proximity switch according to the invention;
FIG. 5 is a perspective view of a first embodiment of a proximity sensor according to the invention; and
FIG. 6 is a perspective view of a second embodiment of a proximity sensor according to the invention.

### DETAILED DESCRIPTION OF A PREFERRED EMBODIMENT

While the invention may be susceptible to embodiment in different forms, there are shown in the drawings and herein will be described in detail, specific embodiments with the understanding that the present disclosure is to be considered an exemplification of the principles of the invention and that it is not intended to limit the invention to that as is illustrated and described herein.

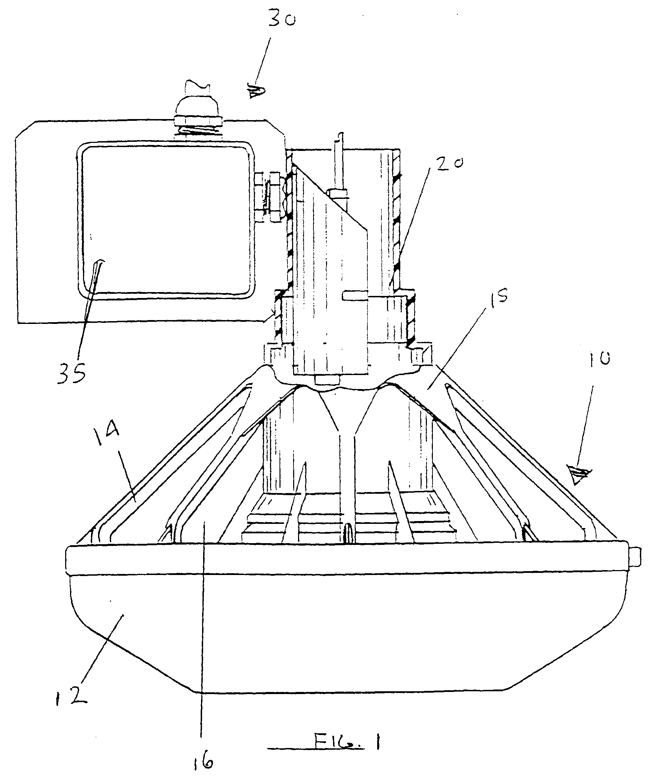

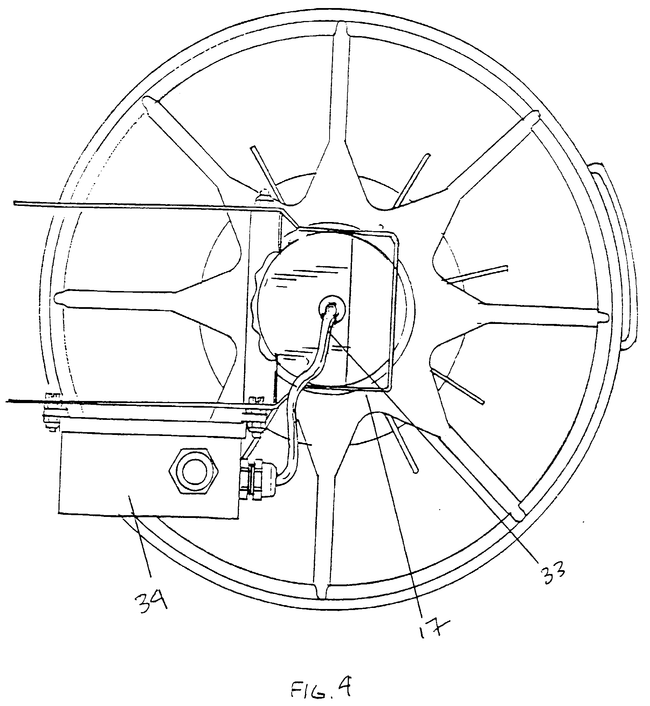

Turning now to the illustrated example in the drawings, FIG. 1 shows a feeder pan 10, from which a plurality of roosters, hens or other types of poultry may eat, suitable for use with the present invention. As illustrated, the feeder pan 10 includes a proximity switch 30 according to the invention. Although a particular type of feeder pan is illustrated, it will be understood by those skilled in the art that the present invention may be used with other types of feeder pans and is not limited to the example shown. The feeder pan 10 includes a generally bowl-shaped pan portion 12 in which feed grain may be presented to consuming poultry. A plurality of separation grills 14 are provided about the circumference of the pan portion 12. The separation grills 14 divide the feeder pan into a plurality of individual feed spaces 16. The separation grills 14 radiate generally downwardly from a central drop tube 20 of the feeder 10. As best seen in FIG. 4, an upper part 15 of the separation grills 14 forms a generally annular portion 17, which surrounds the drop tube 20. Also provided, preferably in the vicinity of the drop tube 20 is the proximity switch 30 according to the present invention. The proximity switch 30 is coupled to the drop tube 20 for detecting whether additional grain should be supplied to the pan 10.

The drop tube 20 is adapted for attachment to a feeder line 40 (not illustrated ) for supplying feed grain to the pan 10. Specifically, the drop tube 20 comprises a vertical fill tube through which the feeder pan 10 is filled with feed grain. The proximity switch 30 detects the level of grain in the fill tube 25 to determine whether additional feed should be supplied to the pan 10.

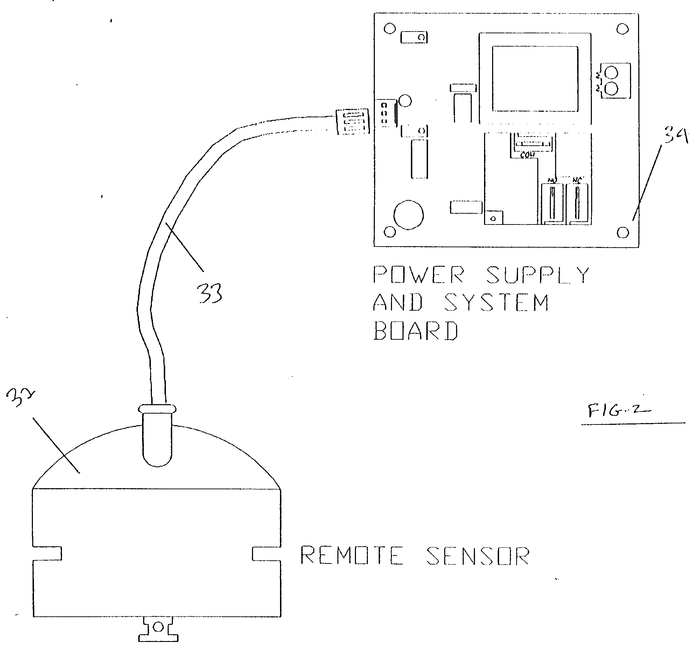

Attention will now be directed to the construction of the proximity switch 30. In this regard, attention is directed to FIG. 2 which shows a perspective view of a proximity switch according to the invention. As illustrated, the proximity switch 30 includes a sensor 32 and control circuitry or electronics 34. The sensor 32 is coupled to the control circuitry through a wire connection 33. The wire connection 33 can be seen clearly in FIG.4.

The control circuitry 34 is provided in the form of a printed circuit board and acts as the power supply for the sensor 32. The control circuitry may be provided with a cover 35, as shown in FIG. 1 for protecting the circuitry. In the present invention, the printed circuit board or control circuitry 34 is advantageously provided with a heating element 36. The heating element 36 keeps the electronics 35 of the printed circuit board 34 warm. In a preferred embodiment, the heating element 36 is adapted to maintain the circuit board 34 at a predetermined temperature, e.g., 70 degrees F. By keeping the control electronics warm, moisture condensation and damage are drastically reduced. Specifically, the warmth of the heating element tends to dissipate any moisture around the circuitry or electronics into the surrounding air. By reducing moisture condensation and damage, the present invention greatly increases the life of the proximity switch 30 and improves its performance.

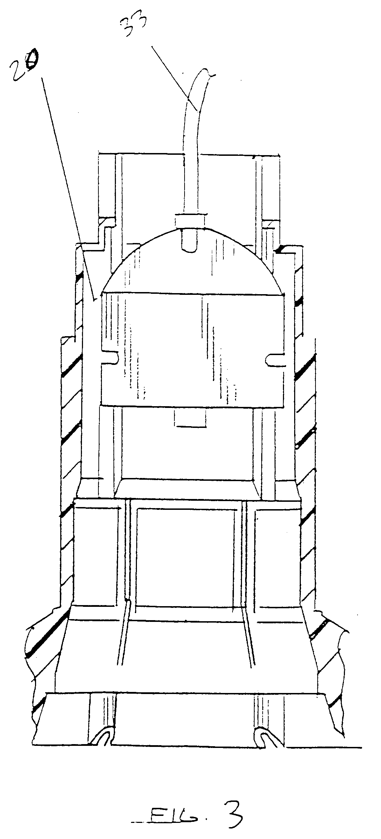

It will be noted that in the present invention, unlike in conventional devices, the sensor 32 is advantageously remote from the control circuitry 34. In the embodiment shown in FIG. 1, this remote arrangement is enhanced by mounting the sensor 32 in the fill tube 20 and attaching the control circuit or electronics to the outside of and in the vicinity of the drop tube 20. The positioning of the sensor 32 in the fill tube 20 can be seen clearly in FIG. 3. Placing the sensor 32 remotely from the control electronics 34 provides a significant advantage in that the sensor 32 is shielded from the electronic noise generated by the control electronics 34. As is well known in the art, electronic noise can interfere with the functioning of the sensor and give rise to inaccurate readings. Additionally, remote placement of the sensor allows for the elimination and replacement of certain electrical components in the control electronics, rendering the switch 30 more economical to manufacture. For example, the need for an electrical relay commonly used in switches of this type is avoided. Accordingly, the present invention by forming the sensor 32 remotely of the control circuitry 34, greatly improves the reliability of and operational characteristics of the sensor 32.

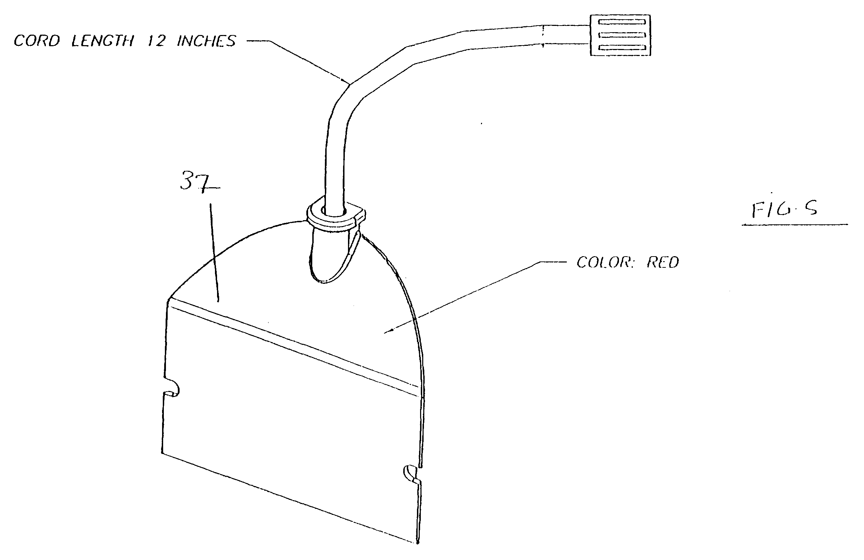

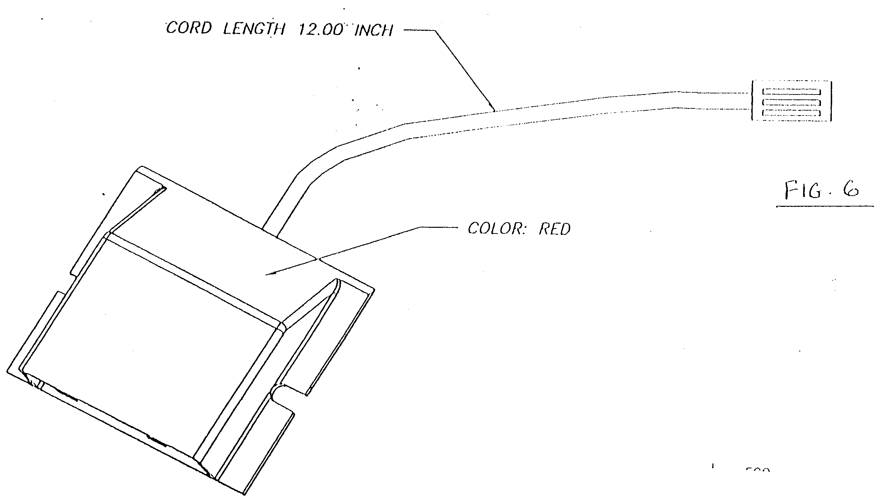

The provision of a remote sensor 32 also gives rise to another advantage. Specifically, the sensor 32 can be readily provided in a number of different shapes and sizes to accommodate different feeder pans. Thus, the provision of a remote sensor greatly increases the adaptability of the proximity switch 30 of the present invention in connection with the illustrated example. Moreover, it is important to note that FIGS. 5 and 6 show only two possible embodiments of the sensor 32 of the present invention. Of course, it will be understood by those skilled in the art that the sensor 32 could be provided in many other forms and is not limited to the examples shown. FIG. 5 shows a sensor 32 having a semicircular upper portion 37, which is suitable for use with the feeder pan shown in FIG. 1. FIG. 6 shows a generally rectangular sensor for use on a feed bin, for example. The versatility of this arrangement enables a wide variety of applications. Also, the sensor of FIG. 6 advantageously includes a heating element for promoting the dissipation of moisture. As discussed above in relation to the printed circuit board 34, by reducing or preventing moisture from condensing on the sensor 32, the reliability and operational characteristics of the sensor 32 are greatly enhanced.

Yet another advantage derived from the novel arrangement of the proximity switch 30 of the present invention relates to replacement of parts. That is, because the sensor 32 and control circuitry 34 constitute discrete components of the proximity switch 30, either component can be replaced when needed, independent of the other. This reduces costs relating to parts as well as labor.

The operation of the present invention will now be described. As stated above, the sensor 32 is mounted within the fill tube 20 of the feeder pan and the control circuitry is attached to a remote location, preferably in the same general vicinity. The sensor 32 and control circuitry are coupled via a wire connection 33. The sensor 32 continuously monitors the level of feed grain in the drop tube 20. When the feed grain reaches a first predetermined level, the sensor 32 generates a first electronic signal 45. The first electronic signal is transmitted to the control circuitry 33. In response to the first electronic signal, the control circuitry causes the feed line to be turned off. When the feed grain falls below a second predetermined level, the sensor 32 generates a second electronic signal 50. The second electronic signal is transmitted to the control circuitry 34. In response to the second control signal, the control circuitry causes the feed line to be turned on.

Thus, an improved proximity switch has been described. The proximity switch of the present invention has improved reliability, greater longevity, and is far more adaptable and versatile as compared to conventional devices of this type and kind. The proximity switch of the present invention is also much more economical to manufacture as a result of its novel construction. The remote mounting shields the sensor from electronic noise and improves its performance. Remote mounting also increases the adaptability of the proximity switch of the present invention and enables the use of less expensive circuitry components.

## Claims

1. A proximity switch (30) for controlling the supply of material from a material feed line to a predetermined location, said proximity switch (30) comprising:
a sensor (32) for sensing the presence or absence of material in the predetermined location, the sensor (32) being adapted to transmit a first control signal (45) when the material is present in the predetermined location and being adapted to generate a second control signal (50) when the material is absent from the predetermined location; and
control means (34) connected to the sensor (32) for receiving said first (45) and second (50) control signals from said sensor (32) and being adapted to activate the material feed line when the second control signal (50) is received and deactivate the material feed line when the first control signal (45) is received;
wherein said sensor (32) is remotely located from said control means (34).

2. A proximity switch (30) according to claim 1 further comprising a heating element (36) which is adapted to maintain the control means (34) at a predetermined temperature.

3. A proximity switch (30) according to claim 1 in which the control means (34) is connected to the sensor (32) via a wire connection (33).

4. A proximity switch (30) according to claim 1 in which said control means (34) supplies power to said sensor (34).

5. A proximity switch (30) according to claim 1 in which said sensor (32) is provided with a sensor heating element for keeping the sensor warm.

6. A proximity switch (30) according to claim 5 in which said sensor heating element is adapted to maintain the sensor at a predetermined temperature.

7. A proximity switch (30) according to claim 1 wherein the control means (34) does not include an electric relay switch.
